# EUROPEAN PATENT APPLICATION

(11) **EP 4 335 899 A1**
(43) Date of publication of application: **13.03.2024**
(21) Application number: 22798839.1
(22) Date of filing: 22.03.2022
(51) Int. Cl.: C08K 5/09, C08L 101/00, H01B 1/00, H01B 1/22, C08K 3/08, C08K 3/11

(54) **ELECTROCONDUCTIVE RESIN COMPOSITION**

(30) Priority: 07.05.2021 JP 2021079191
(71) Applicant: Sakata INX Corporation, Osaka-shi, Osaka 550-0002 (JP)
(72) Inventor: SHIRAKAWA, Yuki, Osaka-shi, Osaka 550-0002 (JP)
(74) Representative: Grünecker Patent- und Rechtsanwälte PartG mbB
(86) International application number: PCT/JP2022/013037
(87) International publication number: WO 2022/234732

(57) **Abstract**

An object is to provide a conductive resin composition that offers low volume resistivity and demonstrates good conductivity when formed into a conductive film, can be used in place of silver paste, and proves useful as a conductive ink, circuit connection material, etc. As a solution, a conductive resin composition is provided that contains a tin powder, resin, and organic acid compound.

## Description

### Technical Field

The present invention relates to a conductive resin composition. The present invention also relates to a conductive film, a conductive ink used for screen printing on base materials to form circuits, etc., and a circuit connection material used for conductively connecting electronic components to circuit boards, etc.

### Background Art

Conductive resin compositions having many different compositional makeups are known, that are used as conductive pastes, conductive films, conductive inks, conductive paints, circuit connection materials, conductive adhesives, etc., for forming electronic circuits and bonding electronic components and in various other applications.

For example, there is a demand for conductive films that are useful in forming conductive circuits, electrodes, and other conductive structures.

Another example is a demand for conductive inks that can be applied under various printing methods and are useful in the manufacture of flexible plastic base materials, etc., having interconnections, traces, electrodes, and other conductive structures.

Yet another example is a demand, in the field of computers, mobile phones, and other electronic devices, for circuit connection materials that enable a high-density mounting and high integration of LED elements, semiconductor elements, capacitors, and various other electronic components on the same circuit board.

The conductive compositions heretofore known include conductive resin compositions (conductive pastes) containing resins and conductive particles. However, conductive resin compositions cannot offer sufficiently low volume resistivities, which necessitates a use of silver particles as conductive particles in applications where low volume resistivities are required.

For example, Patent Literature 1 discloses a conductive paste composition whose conductive powder is a silver-based powder that uses at least silver, whose resin component comprises at least one of thermosetting resin and thermoplastic resin, and which further contains an ester-based compound or salt thereof or ether/amine-based compound having specific molecular weight and structure.

### Background Art Literature

### Patent Literature

Patent Literature 1: Japanese Patent Laid-open No. 2020-205245

### Summary of the Invention

### Problems to Be Solved by the Invention

However, silver particles are very expensive and thus unfavorable in terms of cost, and they also present problems such as the silver being easily oxidized. If conductive particles other than silver particles are used, on the other hand, the volume resistivity of the film formed by the conductive resin composition may rise and lead to insufficient conductivity.

No conductive resin composition is heretofore known that offers low volume resistivity and demonstrates good conductivity when formed into a conductive film, and can be used in place of silver paste without having to use expensive silver particles.

An object of the present invention is to provide a conductive resin composition that offers low volume resistivity and demonstrates good conductivity when formed into a conductive film, can be used in place of silver paste, and proves useful as a conductive ink, circuit connection material, etc.

### Means for Solving the Problems

As a result of studying in earnest to achieve the aforementioned object, the inventors of the present invention found that the aforementioned object could be achieved by a conductive resin composition of specific compositional makeup, and eventually completed the present invention.

To be specific, the present invention is as described below.
1: A conductive resin composition containing a tin powder, resin, and organic acid compound.
2: The conductive resin composition according to 1, which contains a lead-free solder powder.
3: The conductive resin composition according to 1 or 2, wherein the resin includes one or more types selected from the group consisting of polyvinyl butyral-based resins, resol-type phenol-based resins, acrylic-based resins, polyester-based resins, phenoxy resins, polyimide-based resins, epoxy-based resins, and xylene-based resins.
4: A conductive film having a volume resistivity of under 1.0×10⁻² Ω•cm, formed of the conductive resin composition according to any one of 1 to 3.
5: A conductive ink containing the conductive resin composition according to any one of 1 to 3.
6: A circuit connection material containing the conductive resin composition according to any one of 1 to 3.

### Effects of the Invention

The present invention demonstrates prominent effects in that a conductive resin composition can be obtained that offers low volume resistivity and demonstrates good conductivity when formed into a conductive film, can be used in place of silver paste, and proves useful as a conductive ink, circuit connection material, etc.

Furthermore, the conductive resin composition proposed by the present invention can lower heating temperatures for forming conductive connections, which allows for use, as base materials, of low-melting-point plastics that are not conventionally used as base materials.

The conductive resin composition proposed by the present invention is useful as a printed electronic material, and extremely useful in the mass-production of display devices, vehicle-related components, IoT, mobile communication systems, and various other electronic devices, etc.

### Mode for Carrying Out the Invention

The present invention relates to a conductive resin composition, a conductive film, a conductive ink, and a circuit connection material. These are explained in detail below.

### [Conductive Resin Composition]

### <Tin Powder>

The tin powder contained in the conductive resin composition proposed by the present invention is a powder comprising tin that accounts for 99.5% by mass or more, as well as unavoidable impurities.

The content of tin in the tin powder can be easily measured using an X-ray fluorescence (XRF) analysis device, etc.

The unavoidable impurities contained in the tin powder include one or more types of other atoms selected from the group that consists of, for example, Mn, Sb, Si, K, Na, Li, Ba, Sr, Ca, Mg, Be, Zn, Pb, Cd, Tl, V, Al, Zr, W, Mo, Ti, Co, Ag, Cu, Ni, Au, B, C, N, O, Ge, Sb, In, As, Al, Fe, etc.

The content of other atoms is preferably under 0.3% by mass, or more preferably 0.1% by mass or lower, in the tin powder.

The shape of tin powder is not specifically limited. For example, a tin powder of scale-like (flaky), flat, perfect spherical, approximately spherical (such as having a length-to-width aspect ratio of 1.5 or lower), block-like, plate-like, polygonal pyramid-like, polyhedral, bar-like, fibrous, needle-like, amorphous, or other shape may be used according to the application, etc. Under the present invention, a tin powder of scale-like, perfect spherical, approximately spherical, or flat shape is preferred from the viewpoints of volume resistivity, dispersibility, ease of handling, etc.

The volume-average particle size of spherical tin powder is not specifically limited. The D50 is 0.5 µm or more, or preferably 1.0 µm or more, or more preferably 3.0 µm or more, for example, and 300 µm or less, or preferably 200 µm or less, or more preferably 100 µm or less, for example. When the D50 is 0.5 µm or more, the tin powder will have good dispersibility and ease of handling. When the D50 is 300 µm or less, volume resistivity can be lowered, resulting in good dispersibility and ease of handling.

The average diameter, average thickness, and aspect ratio (average diameter/average thickness) of flat or scale-like tin powder are not specifically limited.

The average diameter is 0.5 µm or more, or preferably 1.0 µm or more, or more preferably 5.0 µm or more, for example, and 500.0 µm or less, or preferably 300.0 µm or less, or more preferably 150.0 µm or less, for example.

The average thickness is 0.1 µm or more, or preferably 0.5 µm or more, or more preferably 1.0 µm or more, for example, and 50.0 µm or less, or preferably 20.0 µm or less, or more preferably 10.0 µm or less, for example.

The aspect ratio is 2 or higher, or preferably 10 or higher, or more preferably 50 or higher, for example.

The content of tin powder in the conductive resin composition is not specifically limited. It can be determined as deemed appropriate from the viewpoints of conductivity, etc., of the conductive resin composition. Assuming that the total amount of all solids in the conductive resin composition is 100% by mass, the tin powder accounts for 5.0 to 97.0% by mass, or preferably 60.0 to 97.0% by mass, or more preferably 85.0 to 97.0% by mass, or yet more preferably 90.0 to 97.0% by mass, for example.

### <Resins>

The resins contained in the conductive resin composition proposed by the present invention may be each a thermoplastic resin or thermosetting resin, where one type may be used alone or two or more types may be combined.

Among the thermoplastic resins, one or more types may be selected from the group that consists of, for example, polyvinyl butyral-based resins, acrylic-based resins, polyester-based resins, phenoxy resins, polyimide-based resins, polyolefin-based resins, thermoplastic polyurethane-based resins, polyamide-based resins, polycarbonate-based resins, polyphenylene ether-based resins, polyvinyl ether-based resins, polyvinyl alcohol-based resins, polyvinyl acetate-based resins, ionomer resins, etc.

Among the thermosetting resins, one or more types may be selected from the group that consists of, for example, resol-type phenol-based resins, polyimide-based resins, epoxy-based resins, xylene-based resins, polyurethane-based resins, melamine-based resins, urea-based resins, etc.

Under the present invention, preferably one or more types of resins selected from the group that consists of polyvinyl butyral-based resins, resol-type phenol-based resins, acrylic-based resins, polyester-based resins, phenoxy resins, polyimide-based resins, epoxy-based resins, and xylene-based resins is/are contained. More preferably one or more types selected from the group that consists of, among the above, polyvinyl butyral-based resins, resol-type phenol-based resins, acrylic-based resins, polyester-based resins, phenoxy resins, polyimide-based resins, and xylene-based resins is/are contained.

Of these, polyvinyl butyral-based resins are used favorably from the viewpoints of condition of formed film, connection reliability, adhesion to base materials, etc.

Polyvinyl butyral-based resins are resins obtained by acetalizing the alcohol part of a polyvinyl alcohol with butyraldehyde. In general, they are thermoplastic resins that contain vinyl butyral units expressed by Formula (1) below, vinyl acetate units expressed by Formula (2) below, and vinyl alcohol units expressed by Formula (3) below, as primary repeating units.

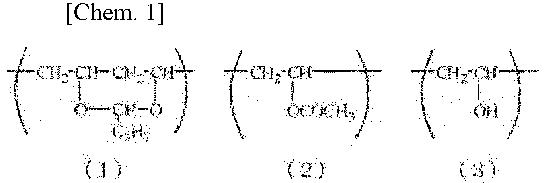

Polyvinyl butyral-based resins change their physical properties, chemical properties, and mechanical properties, etc., according to the ratio of each of the units conforming to Formulas (1) to (3) above as well as the weight-average molecular weight (polymerization degree).

For example, when there are more vinyl butyral units expressed by Formula (1) in a polyvinyl butyral-based resin (higher degree of butyralization), the resin's compatibility, solubility in nonpolar solvents, etc., will improve. When there are more vinyl acetate units expressed by Formula (2) (greater amount of acetyl groups), viscosity of the resin in a solvent-dissolved state can be lowered, which in turns allows for lowering of the glass transition temperature of the resin. When there are more vinyl alcohol units expressed by Formula (3), the resin's adhesive property, solubility in polar solvents, etc., can be improved.

Under the present invention, the quantitative ratio of each of the butyral groups, acetyl groups, and hydroxyl groups in a polyvinyl butyral-based resin is not specifically limited. For example, assuming that the total amount of these groups is 100 mol, the butyral groups, acetyl groups, and hydroxyl groups may account for 55% by mol to 80% by mol, 25% by mol or less, and 10 to 20% by mol, respectively.

It should be noted that, under the present invention, the greater the amount of acetyl groups, the better. For example, preferably polyvinyl butyral-based resins containing acetyl groups amounting to 7 to 25% by mol are used.

The weight-average molecular weight of polyvinyl butyral-based resin is not specifically limited. From the viewpoints of the mechanical characteristics of the conductive resin composition, its compatibility with solvents, and so on, it can be 10,000 to 250,000, or preferably 20,000 to 120,000.

Polyvinyl butyral-based resins may be synthesized at the time of preparation of the conductive resin composition, or commercial products may be used.

If synthesized, any known method may be used without limitation. Examples include a method of causing an aqueous solution of polyvinyl alcohol to react with butyraldehyde in the presence of an acid catalyst, neutralizing the produced slurry of polyvinyl butyral-based resin with an alkali, separating the solvent, and then washing/dewatering and subsequently drying the remaining substance, to manufacturer a resin in powder form.

Among the commercial products of polyvinyl butyral-based resins, one or more types selected from the group that consists of, for example, those under the product name S-LEC Series manufactured by Sekisui Chemical Co., Ltd. (such as BL-1, BL-1H, BL-2H, BL-5Z, BL-7Z, BL-10, BL-S, BM-1, BM-2, BM-5, BM-S, BM-SHZ, BH-3, BH-6, BH-A, BH-S, BX-1, BX-L, BX-3, BX-5, KS-1, KS-5Z, KS-6Z, KS-10, KX-1, KX-5, KW-M, KW-10, SV-12, SV-16, SV-22, SV-26, etc.), and those under the product name MOWITAL Series manufactured by Kurary Co., Ltd. (such as LPB16B, B20H, 30T, 30H, 30HH, 45M, 45H, 60H, 60T, 60HH, 70HH, 75H, etc.), may be used.

The content of resins in the conductive resin composition is not specifically limited. It can be determined as deemed appropriate from the viewpoints of the conductivity, etc., of the conductive resin composition. Assuming that the total amount of all solids in the conductive resin composition is 100% by mass, the resins account for 1.0 to 15.0% by mass, or preferably 1.0 to 12.0% by mass, or more preferably 2.0 to 10.0% by mass, or yet more preferably 3.0 to 10.0% by mass, for example.

### <Organic Acid Compounds>

For the organic acid compounds, one type, or two or more types, of organic acid compound(s) expressed by R-Xₙ (in the formula, R is hydrogen or an organic group with 1 to 50 carbon atoms, X is an acid group where the multiple X's may be different from each other, and n is an integer of 1 or greater) is/are considered, for example.

The acid group expressed by X may be, for example, a carboxyl group (-COOH), carboxylic acid anhydride group (-C(=O)-O-C(=O)-), sulfonic acid group (-SO₃H), phosphoric acid group (-PO₃H₂), etc.

For the organic acid compounds, one or more types may be selected from the group that consists of, for example, organic carboxylic acid compounds, organic carboxylic acid anhydrides, organic sulfonic acid compounds, organic phosphonic acid compounds, etc. Organic carboxylic acid compounds and/or organic carboxylic acid anhydrides are preferred.

Use of organic acid compounds improves dispersibility, etc., of the tin powder to allow for its efficient placement, resulting in higher reliability of conductive connection property and insulation property.

### (Organic Carboxylic Acid Compounds)

The organic carboxylic acid compounds are not specifically limited so long as they are compounds with 1 to 50 carbon atoms having one or more carboxyl groups (-COOH) in the molecular structure.

Among the organic carboxylic acid compounds, one or more types may be selected from the group that consists of, for example, formic acid, acetic acid, propionic acid, butanoic acid, pentanoic acid, hexanoic acid, heptanoic acid, octylic acid, lauric acid, myristic acid, pentadecylic acid, palmitic acid, margaric acid, stearic acid, 12-hydroxystearic acid, recinoleic acid, oleic acid, vaccenic acid, linoleic acid, linolenic acid, arachidic acid, behenic acid, lignoceric acid, cerotic acid, montanic acid, melissic acid, lactic acid, gluconic acid, malic acid, tartaric acid, citric acid, ascorbic acid, abietic acid, malonic acid, succinic acid, glutaric acid, adipic acid, glutaconic acid, pimelic acid, suberic acid, azelaic acid, sebacic acid, decanedioic acid dodecanedioic acid, eicosonic acid diacid, caproic acid, enanthic acid, caprylic acid, pelargonic acid, capric acid, arachidonic acid, eicosapentaenoic acid, docosahexaenoic acid, dodecenylsuccinic acid, citraconic acid, mesaconic acid, itaconic acid, dimethylolpropionic acid, dimethylolbutanoic acid, dimethylolbutyric acid, dimethylolvaleric acid, trimethylolpropanoic acid, trimethylolbutanoic acid, benzoic acid, salicylic acid, pyruvic acid, paramethylbenzoic acid, toluic acid, 4-ethylbenzoic acid, 4-propylbenzoic acid, 2-methylpropanoic acid, isopentanoic acid, 2-ethylhexanoic acid, acrylic acid, methacrylic acid, propiolic acid, crotonic acid, 2-ethyl-2-butenoic acid, maleic acid, fumaric acid, oxalic acid, hexane tricarboxylic acid, cyclohexyl carboxylic acid, 1,4-cyclohexyl dicarboxylic acid, ethylenediamine tetraacetic acid, isophthalic acid, terephthalic acid, naphthalene dicarboxylic acid, trimellitic acid, pyromellitic acid, etc.

### (Organic Carboxylic Acid Anhydrides)

The organic carboxylic acid anhydrides are not specifically limited so long as they are compounds having one or more carboxylic acid anhydride groups (-C(=O)-O-C(=O)-) in the molecular structure.

Organic carboxylic acid anhydrides are obtained by dewatering between two organic carboxylic acid molecules and/or dewatering within one organic carboxylic acid molecule. Under the present invention, one or more types may be selected from the group that consists of, among the aforementioned organic carboxylic acids, those obtained by intermolecular dewatering of organic monocarboxylic acids and those obtained by molecular dewatering of an organic polycarboxylic acid.

Preferred is/are one or more types selected from the group that consists of acetic acid anhydrides, propionic acid anhydrides, oxalic acid anhydrides, maleic acid anhydrides, phthalic acid anhydrides, benzoic acid anhydrides, succinic acid anhydrides, 2-methylsuccinic acid anhydrides, trimellitic anhydrides, etc.

### (Organic Sulfonic Acid Compounds)

The organic sulfonic acid compounds are not specifically limited so long as they are compounds having one or more sulfonic acid groups (-SO₃H) in the molecular structure.

Examples include one or more types selected from the group that consists of: benzenesulfonic acid, n-butylbenzenesulfonic acid, n-octylbenzenesulfonic acid, n-dodecylbenzenesulfonic acid, pentadecylbenzenesulfonic acid, 2,5-dimethylbenzenesulfonic acid, p-chlorobenzenesulfonic acid, 2,5-dichlorobenzenesulfonic acid, p-phenolsulfonic acid, cumenesulfonic acid, xylenesulfonic acid, o-cresolsulfonic acid, m-cresolsulfonic acid, p-cresolsulfonic acid, p-toluenesulfonic acid, 2-naphthalenesulfonic acid, 1-naphthalenesulfonic acid, styrenesulfonic acid, 4,4-biphenyldisulfonic acid, anthraquinone-2-sulfonic acid, m-benzenedisulfonic acid, aniline-2,4-disulfonic acid, anthraquinone-1,5-disulfonic acid, polystyrenesulfonic acid, and other aromatic sulfonic acid compounds; methanesulfonic acid, ethanesulfonic acid, 1-propanesulfonic acid, n-octylsulfonic acid, pentadecylsulfonic acid, trifluoromethanesulfonic acid, trichloromethanesulfonic acid, 1,2-ethanedisulfonic acid, 1,3-propanedisulfonic acid, aminomethanesulfonic acid, 2-aminoethanesulfonic acid, and other aliphatic sulfonic acid compounds; and cyclopentanesulfonic acid, cyclohexanesulfonic acid, 3-cyclohexylaminopropanesulfonic acid alicyclic sulfonic acid compounds; for example.

Preferred is/are one or more types selected from the group that consists of benzenesulfonic acid, dodecylbenzenesulfonic acid, methanesulfonic acid, p-phenolsulfonic acid, p-toluenesulfonic acid, (poly)styrenesulfonic acid, etc.

### (Organic Phosphonic Acid Compounds)

The organic phosphonic acid compounds are not specifically limited so long as they are compounds having one or more phosphoric acid groups (-PO₃H₂) in the molecular structure.

Examples include one or more types selected from the group that consists of 1-hydroxyethylidene-1,1-diphosphonic acid, 1-hydroxypropylidene-1,1-diphosphonic acid, 1-hydroxybutylidene-1,1-diphosphonic acid, aminotrimethylenephosphonic acid, methyldiphosphonic acid, nitrotrismethylenephosphonic acid, ethylenediamine tetramethylenephosphonic acid, ethylenediamine bismethylenephosphonic acid, hexamethylenediamine tetramethylenephosphonic acid, diethylenetriamine pentamethylenephosphonic acid, cyclohexanediamine tetramethylenephosphonic acid, carboxyethylphosphonic acid, phosphonoacetic acid, 2-phosphonobutane-1,2,4-tricarboxylic acid, 2,3-dicarboxypropane-1,1-diphosphonic acid, phosphonobutyric acid, phosphonopropionic acid, sulfonylmethylphosphonic acid, N-carboxymethyl-N,N-dimethylenephosphonic acid, N,N-dicarboxymethyl-N-methylenephosphonic acid, 2-ethylhexyl acid phosphate, stearyl acid phosphate, benzenephosphonic acid, etc.

The organic phosphonic acid compounds may be surfactants having phosphoric acid groups in the molecular structure.

Among the surfactants having phosphoric acid groups, those having polyoxyethylene groups or phenyl groups in the molecular structure are preferred. Examples include one or more types selected from the group that consists of polyoxyethylene alkylphenyl ether phosphoric acid, polyoxyethylene alkyl ether phosphoric acid, dipolyoxypropylene lauryl ether phosphoric acid, dipolyoxyethylene oleyl ether phosphoric acid, dipolyoxyethylene oxypropylene lauryl ether phosphoric acid, dipolyoxypropylene oleyl ether phosphoric acid, ammonium lauryl phosphate, ammonium octyl ether phosphate, ammonium cetyl ether phosphate, polyoxyethylene lauryl ether phosphoric acid, polyoxyethylene oxypropylene lauryl ether phosphoric acid, polyoxypropylene lauryl ether phosphoric acid, polyoxyethylene tristyrylphenyl ether phosphoric acid, polyoxyethylene oxypropylene tristyrylphenyl ether phosphoric acid, polyoxypropylene tristyrylphenyl ether phosphoric acid, etc.

For the surfactants having phosphoric acid groups, one or more types selected from the group that consists of commercial products such as those under the product name PHOSPHANOL manufactured by Toho Chemical Industry Co., Ltd., DISPERBYK manufactured by BYK-Chemie Japan K.K., etc., may be used.

### (Content)

The content of organic acid compounds in the conductive resin composition is not specifically limited. It can be determined as deemed appropriate from the viewpoints of conductivity, stability, etc., of the conductive resin composition. Assuming that the total amount of all solids in the conductive resin composition is 100% by mass, the organic acid compounds account for 0.1 to 10.0% by mass, or preferably 0.1 to 8.0% by mass, or more preferably 0.5 to 7.0% by mass, or yet more preferably 0.5 to 4.0% by mass, for example.

### <Lead-free Solder Powders>

The conductive resin composition proposed by the present invention may contain lead-free solder particles. The lead-free solders are not specifically limited so long as they are solders containing no more than an unavoidable amount of lead in view of impact on workers, users, the environment, etc.

The melting point of lead-free solder powder is preferably 300°C or lower, or more preferably 220°C or lower, or yet more preferably from 50 to 220°C. If the melting point of lead-free solder powder exceeds 300°C, the connected members of circuit boards, electronic components, etc., may undergo thermal failure or thermal degradation. If the melting point is under 50°C, a weaker mechanical strength may cause conductive connection reliability to drop.

Among the lead-free solder powders, one or more types may be selected from the group that consists of, for example, lead-free solder powders based on tin (Sn) and containing one or more types of elements selected from the group that consists of silver (Ag), bismuth (Bi), zinc (Zn), copper (Cu), Indium (In), aluminum (Al), antimony (Sb), etc. (such as Sn-Bi-based, Sn-Cu-based, Sn-Sb-based, Sn-Zn-based, Sn-Ag-based, Sn-Ag-Cu-based, Sn-Zn-Bi-based, Sn-Ag-In-Bi-based, Sn-Zn-Al-based, Sn-Ag-Bi-based, Sn-Ag-Cu-Bi-based and Sn-Ag-Cu-Bi-In-Sb-based powders, etc.), lead-free solder powders based on Bi (Bi-In-based powders, etc.), and lead-free powders based on In (In-Ag-based and In-Bi-based powders, etc.).

The shape of lead-free solder powder is not specifically limited. For example, lead-free powders of perfect spherical, approximately spherical (such as having a length-to-width aspect ratio of 1.5 or lower), flat, polyhedral, scale-like, fibrous, amorphous, or other shapes may be used according to the application, etc. Under the present invention, lead-free powders of perfect spherical, approximately spherical, flat, or scale-like shapes are preferred from the viewpoints of connection stability, volume resistivity, dispersibility, ease of handling, etc.

The volume-average particle size of lead-free solder powder is not specifically limited. For example, the D50 may be 0.5 µm to 50 µm, or preferably 1 µm to 40 µm, or more preferably 3 µm to 30 µm. If the D50 is under 0.5 µm, dispersibility and ease of handling of the lead-free solder powder may drop. A D50 exceeding 50 µm may result in lower connection stability, higher volume resistivity, and lower dispersibility and ease of handling.

The content of lead-free solder powders in the conductive resin composition is not specifically limited. It can be determined as deemed appropriate from the viewpoints of conductivity, etc., of the conductive resin composition. Assuming that the total amount of all solids in the conductive resin composition is 100% by mass, the lead-free solder powders account for 5.0 to 85.0% by mass, or preferably 10.0 to 82.0% by mass, or more preferably 20.0 to 80.0% by mass, or yet more preferably 25.0 to 80.0% by mass, for example.

### <Other Components>

The conductive resin composition proposed by the present invention may have one or more types of various additives mixed therein, as necessary, that are selected from the group that consists of solvents, pigments, conductive powders other than tin powder/lead-free solder powders, fillers, antioxidants, anticorrosive agents, defoaming agents, dispersants, viscosity-adjusting agents (thixotropy-adjusting agents), adhesion-imparting agents, coupling agents, anti-settling agents, leveling agents, etc.

### (Solvents)

The conductive resin composition proposed by the present invention may contain solvents. When solvents are contained, flowability of the conductive resin composition can be improved, contributing to better workability. Also, mixing the conductive resin composition with solvents makes it possible to constitute conductive resin pastes, conductive inks, and circuit connection agents.

Among the solvents, one or more desired types selected from the group that consists of water and various organic solvents may be used. Among the organic solvents, one or more types may be selected from the group that consists of, for example: ethyl alcohol, propyl alcohol, butyl alcohol, pentyl alcohol, hexyl alcohol, heptyl alcohol, octyl alcohol, nonyl alcohol, decyl alcohol, ethylene glycol monomethyl ether, ethylene glycol monoethyl ether, ethylene glycol monopropyl ether, ethylene glycol monobutyl ether, propylene glycol monomethyl ether, propylene glycol monoethyl ether, propylene glycol monopropyl ether, propylene glycol monobutyl ether, methyl methoxy butanol, α-terpineol, β-terpineol, hexylene glycol, benzyl alcohol, 2-phenylethyl alcohol, isopalmityl alcohol, isostearyl alcohol, lauryl alcohol, ethylene glycol, propylene glycol, or glycerin and other alcohols; acetone, methyl ethyl ketone, methyl isobutyl ketone, cyclohexanone, diacetone alcohol (4-hydroxy-4-methyl-2-pentanone), 2-octanone, isophorone (3,5,5-trimethyl-2-chclohexene-1-one) or diisobutyl ketone (2,6-dimethyl-4-heptanone), and other ketone-based solvents; ethyl acetate, butyl acetate, diethyl phthalate, dibutyl phthalate, acetoxyethane, methyl butyrate, methyl hexanoate, methyl octanoate, methyl decanoate, methyl cellosolve acetate, ethylene glycol monobutyl ether acetate, propylene glycol monomethyl ether acetate, 1,2-diacetoxyethane, and other ester-based solvents; tetrahydrofuran, dimethyl ether, diethyl ether, dipropyl ether, ethylene glycol dimethyl ether, ethylene glycol diethyl ether, ethylene glycol dibutyl ether, propylene glycol dimethyl ether, ethoxyethyl ether, 1,2-bis(2-diethoxy)ethane or 1,2-bis(2-methoxyethoxy)ethane, and other ether-based solvents; 2-(2-butoxyethoxy)ethane acetate and other ester ethers; 2-(2-methoxyethoxy)ethanol and other ether alcohol-based solvents; benzene, toluene, xylene, n-paraffin, isoparaffin, dodecyl benzene, terpene oil, kerosine or light oil, and other hydrocarbon-based solvents; acetonitrile, propionitrile, and other nitrile-based solvents; dimethylacetamide, N,N-dimethylformamide, N-methyl-2-pyrrolidone, and other nitrogen-containing polar solvents; silicone oil-based solvents, etc.

When solvents are used, their use amount is not specifically limited and may be adjusted as deemed appropriate so that viscosity of the conductive resin composition will be at a level that allows the conductive resin composition to be properly applied, printed, etc., on base materials and/or at a level that allows the conductive resin composition to be properly impregnated in porous bodies.

### <State Property of Conductive Resin Composition>

The conductive resin composition proposed by the present invention may have a powdery, solid, paste-like, liquid (varnish-like), or other desired state property. When used as a conductive ink or circuit connection material, preferably the conductive resin composition is in a paste or liquid (varnish) state at room temperature (20°C).

### <Properties of Conductive Resin Composition>

The conductive resin composition proposed by the present invention has excellent conductivity. Conductivity of the conductive resin composition is such that, when the conductive resin composition is cast or applied on a releasable base material, dried, and then released, the obtained conductive film has a volume resistivity under 1.0×10⁻² Ω•cm. It is preferably under 8.0×10⁻³ Ω•cm, or more preferably under 1.0×10⁻³ Ω•cm. Here, volume resistivity is obtained according to the method described in "Examples."

The conductive resin composition proposed by the present invention has excellent adhesion to various base materials. Particularly when it contains polyvinyl butyral-based resins, the conductive resin composition exhibits excellent adhesion to glass or PET.

The conductive resin composition proposed by the present invention can also be formulated to achieve excellent storage stability as demonstrated by, for example, not getting thicker or undergoing other viscosity changes, etc., and also remaining free from sediments, etc., after 60 days of storage.

### <Method for Preparing Conductive Resin Composition>

When preparing the conductive resin composition proposed by the present invention, it can be manufactured by adding the tin powder, resins, and organic acid compounds that are the essential components, as well as lead-free solder powders, solvents, etc., as necessary, to a mixing container in any order and then mixing them together. For mixing, any method for mixing using, for example, a planetary centrifugal mixer, ball mill, roll mill, bead mill, planetary mixer, tumbler, stirrer, agitator, mechanical homogenizer, ultrasonic homogenizer, high-pressure homogenizer, paint shaker, V-type blender, Nauta mixer, Banbury mixer, kneading roll, single-axis or double-axis extruder, etc., may be used as deemed appropriate.

The temperature at which to prepare the conductive resin composition (temperature at which to mix the components) is not specifically limited. Heating, etc., may be applied, as necessary, and the temperature may be in a range of 10 to 100°C, for examples.

The atmosphere in which to prepare the conductive resin composition is not specifically limited. It may be prepared in air, or in an inert atmosphere.

### <Applications of Conductive Resin Composition>

The applications of the conductive resin composition proposed by the present invention are those related to the manufacture of conductive objects. The conductive objects may comprise other members, etc., in addition to the conductive resin composition.

As for the conductive bodies, one or more types selected from the group that consists of, for example, conductive inks, circuit connection materials, conductive pastes, conductive films, conductive fibers, conductive paints, conductive materials for semiconductor packages, conductive materials for microelectronics devices, anti-static materials, electromagnetic shielding materials, anisotropic conductive adhesives (die-attaching adhesives, etc.), die-attaching pastes, actuators, sensors, and conductive molded resin products, is/are considered.

For example, conductive inks, conductive pastes, conductive paints, etc., can be constituted by including solvents as components of the conductive resin composition. In this case, viscosity of the conductive resin composition is not specifically limited, and it may be in any state, from a low-viscosity varnish to high-viscosity paste, etc., according to the application, etc.

For example, the conductive resin composition containing solvents, etc., as necessary, may be applied on various base materials using the casting method, dipping method, bar coating method, dispenser method, roll coating method, gravure coating method, screen printing method, flexographic printing method, spray coating method, spin coating method, or inkjet method, and the like, and then dried by heating at temperatures of 300°C or lower to form conductive films. For the drying atmosphere, one or more types may be selected from the group that consists of air, inert gas, vacuum, reduced pressure, etc. In particular, a nitrogen, argon, or other inert gas atmosphere is preferred from the viewpoint of degradation control of the conductive film (preventing the tin powder, lead-free solder powders, etc., from oxidizing, etc.).

The conductive resin composition proposed by the present invention may be molded by means of extrusion molding, injection molding, compression molding, or other molding method, and used as molded products. The molded products include, for example, electronic device components, automotive components, mechanical and mechanism components, food containers, films, sheets, fibers, etc.

### [Conductive Film]

The conductive film proposed by the present invention is formed by the aforementioned conductive resin composition and its volume resistivity is under 1.0×10⁻² Ω•cm. Volume resistivity of the conductive film is preferably under 8.0×10⁻³ Ω•cm, or more preferably under 1.0×10⁻³ Ω•cm. The conductive film proposed by the present invention can also be formulated to achieve a volume low efficiency matching those of conductive films formed by silver paste, or specifically under 1.0×10⁻⁴ Ω•cm (10⁻⁵ Ω•cm order).

Here, volume resistivity is obtained according to the method described in "Examples."

The method for forming a conductive film from the conductive resin composition is not specifically limited. For example, a solvent-containing version of the aforementioned conductive resin composition can be applied on any base material and then dried, etc., to form a conductive film. Also, the conductive resin composition can be cast or applied on a releasable base material and dried, etc., and then released, to obtain a conductive film.

Forming conditions of conductive film are not specifically limited, and can be set as deemed appropriate according to the object to be coated, etc. The temperature at which to dry, etc., the conductive resin composition following its application is 50°C or higher, or preferably 90°C or higher, for example, and 250°C or lower, or preferably 220°C or lower, for example. The period of drying, etc., is 5 minutes or more, or preferably 7 minutes or more, for example, and 300 minutes or less, or preferably 200 minutes or less, for example.

Dry film thickness of conductive film is not specifically limited, and can be adjusted as deemed appropriate according to the application, etc. It is 10 µm or more, or preferably 30 µm or more, for example, and 1000 µm or less, or preferably 500 µm or less, for example.

### [Conductive Ink]

The conductive ink proposed by the present invention can be obtained by dissolving and/or dispersing the aforementioned conductive resin composition in a solvent.

The conductive ink proposed by the present invention contains a tin powder, resins, organic acid compounds, solvents, and, if necessary, lead-free solder powders, as well as, for example, additive components such as surfactants, pH-adjusting agents (amine-based compounds), leveling agents, pigments, UV absorbents, antioxidants, and flame retardants.

The conductive ink is obtained by placing the aforementioned components in a mixing container and then mixing them together using one or more types of mixers selected from the group that consists of planetary centrifugal mixer, ball mill, roll mill, bead mill, planetary mixer, tumbler, stirrer, agitator, mechanical homogenizer, ultrasonic homogenizer, high-pressure homogenizer, paint shaker, etc., into a varnish or paste state.

The conductive ink proposed by the present invention can be utilized as a conductive printing ink for forming wiring. For the printing method, one or more types may be selected from the group that consists of, for example, screen printing, inkjet printing, flexographic printing, gravure printing, etc. Under the present invention, preferably one or more types of printing method(s) selected from the group that consists of screen printing and inkjet printing is/are used in view of excellent printability and shape retainability associated with them.

Here, any mesh can be selected as deemed appropriate under the screen printing method, but preferably a mesh that does not excessively remove the conductive powder and lead-free solder powders in the conductive ink is adopted.

Film thickness of the coating film produced by applying the conductive ink proposed by the present invention can be adjusted to appropriate thicknesses according to various applications. For example, it is 1 µm or more, or preferably 2 µm or more, or more preferably 5 µm or more, and 100 µm or less.

The conductive ink proposed by the present invention is excellent in one or more types of properties selected from the group that consists of conductivity, adhesion to various base materials, storage stability, leveling (surface smoothness), printability, etc.

### [Circuit Connection Material]

The circuit connection material proposed by the present invention is used for conductively connecting various electronic components and circuit boards, or interconnecting (-bonding) electrical/electronic circuits.

Although the circuit connection material is not specifically limited in shape, etc., preferably it is in a liquid or film state.

A circuit connection material in a liquid state can be obtained by, for example, mixing an organic solvent or other solvent in the conductive resin composition proposed by the present invention and thereby liquifying the conductive resin composition.

A circuit connection material in a film state can be obtained by, for example, directly casting/applying on a releasable base material the conductive resin composition proposed by the present invention that has been liquefied as described above to form a film layer, drying it to remove the solvent, and thereby form a film, and then releasing it from the releasable base material.

Also, a circuit connection material in a film state can be obtained by, for example, impregnating in a nonwoven fabric, etc., the conductive resin composition proposed by the present invention that has been liquefied as described above, and then shaping the impregnated nonwoven fabric, etc., on a releasable base material, drying the nonwoven fabric, etc., to remove the solvent, and then releasing the nonwoven fabric, etc., from the releasable base material.

The circuit connection material proposed by the present invention is not specifically limited in how it can be used to make electrical connections, etc. Examples include a method whereby the circuit connection material is provided between an electrode of an electronic component, circuit, etc., and an electrode facing it on a base material, and then heating the circuit connection material to electrically connect the two electrodes while inter-bonding the electrodes. Pressure can be applied, as necessary, during heating.

The method for providing the circuit connection material between electrodes that are facing each other is not specifically limited. Examples include a method of applying the circuit connection material in a liquid state, a method of sandwiching the circuit connection material in a film state, and so on.

Also, when conductively connecting pins on an electronic component, etc., to a circuit, one method, for example, is to provide the circuit connection material at the base of the pins and butt-join the pins to constitute conductive connections.

The circuit connection material proposed by the present invention can be effectively used as an anisotropic conductive material, while it can also be used under any electrode connection method that involves forming a circuit connection material offering excellent adhesion, between electrodes facing each other on a base material, and then applying heating/pressure to cause the two electrodes to make contact and bond with the base material. For the base material on which the electrodes are formed, semiconductor, glass, ceramic, or other inorganic material, polyimide, polycarbonate, or other organic material, glass/epoxy, or other combination of two or more of the foregoing, may be applied.

Furthermore, the circuit connection material proposed by the present invention makes conductive connections possible at low temperatures of 250°C or lower, such as 200°C or lower, because its components include solder powders that become molten at low temperatures.

### Examples

The present invention is explained in greater detail below by citing examples. It should be noted that the present invention is not limited to these examples. Unless otherwise specified, "%" and "part(s)" represent "% by mass" and "part(s) by mass," respectively.

The tin powders, resin, organic acid compounds, and lead-free solder powders used in the Examples and Comparative Examples are listed below.
<Tin Powders>
   Tin powder 1: Pulverized tin flake powder (Over 70% by mass, has a particle size under 45 µm)
   Tin powder 2: Gass-atomized tin powder (D50 = 73.5 µm, Sn ≥ 99.9% by mass)
   Tin powder 3: Spherical tin powder (D50 = 5.5 µm, Sn ≥ 99.5% by mass)
<Lead-free Solder Powders>
   Lead-free solder 1: Sn42-Bi58 (type 5) (manufactured by Mitsui Mining & Smelting Co., Ltd.)
   Lead-free solder 2: Sn42-Bi58 (type 4) (manufactured by Mitsui Mining & Smelting Co., Ltd.)
   Lead-free solder 3: Sn42-Bi58 (type 9) (manufactured by 5N Plus Inc.)
<Resin>
   Resin 1: Polyvinyl butyral resin (S-LEC BH-A, manufactured by Sekisui Chemical Co., Ltd.)
<Organic Acid Compounds>
   Organic acid 1: Glutaric acid
   Organic acid 2: Dodecanedioic acid (SL-12, manufactured by Okamoto Oil Mill, Ltd.)
   Organic acid 3: Eicosanedioic acid (SL-20, manufactured by Okamoto Oil Mill, Ltd.)
   Organic acid 4: Stearic acid

In each of the Examples and Comparative Examples, the conductive film formed by the conductive resin composition was measured/evaluated for volume resistivity according to the method below.

### <Conductivity>

Using a spin coater, each conductive resin composition was spin-coated to produce a wet coating film on a plastic film base material, which was then sintered, to produce a conductive film having film thicknesses (sintered film thicknesses) listed in Table 1 or Table 2. The conductive film was measured for volume resistivity using a resistivity meter "LORESTA GP-MCP T610" (manufactured by Nittoseiko Analytech Co., Ltd.).

Under the present invention, those producing a conductive film whose volume resistivity was under 1.0×10⁻² Ω•cm were considered acceptable.

### [Example 1]

First, 0.84 parts of resin 1 and 5.00 parts of diethylene glycol monoethyl ether acetate (EDGAC) were mixed to obtain a varnish. Then, 5.84 parts of the produced varnish, 15.00 parts of tin powder 1, and 0.4 parts of organic acid 1 were added together and mixed under agitation using a planetary centrifugal mixer (AWATORI RENTARO AR-100, manufactured by Thinky Corporation), to obtain a conductive resin composition. The solids contents of tin powder, resin, and organic acid in the obtained conductive resin composition are shown in Table 1.

The obtained conductive resin composition was applied on a base material by spin coating using a spin coater under the conditions of 500 rpm for 5 seconds and then 2000 rpm for 30 seconds, followed by heating, to produce a conductive film of 100 µm in dry film thickness, and its conductivity (volume resistivity) was measured. The result is shown in Tables 1 and 2.

### [Examples 2 to 20, Comparative Examples 1, 2]

Conductive resin compositions and conductive films were produced in the same manner as in Example 1, except that the constitutional components of conductive resin compositions, their solids contents, and sintered film thicknesses of coating films, were respectively changed to those shown in Table 1 and Table 2. The conductive films formed by the obtained conductive resin compositions were evaluated for volume resistivity. The results are also shown in Table 1 and Table 2.

**[Table 1]**

| | Examples | | | | | | | | | | |
|---|---|---|---|---|---|---|---|---|---|---|---|
| | 1 | 2 | 3 | 4 | 5 | 6 | 7 | 8 | 9 | 10 | 11 |
| Tin powder 1 | 92.4 | | 88.0 | 88.0 | 82.2 | 61.6 | 60.1 | 46.2 | | | |
| Tin powder 2 | | | | | | | | | 61.6 | 61.6 | 61.6 |
| Tin powder 3 | | 92.4 | | | | | | | 30.8 | 30.8 | 30.8 |
| Lead-free solder 1 | | | | | | 30.8 | 30.1 | 46.2 | | | |
| Lead-free solder 2 | | | | | | | | | | | |
| Lead-free solder 3 | | | | | | | | | | | |
| Resin 1 | 5.2 | 5.2 | 5.0 | 5.0 | 4.6 | 5.2 | 5.0 | 5.2 | 5.2 | 5.2 | 5.2 |
| Organic acid 1 | 2.4 | 2.4 | | | | 2.5 | 4.8 | 2.5 | 2.5 | 2.5 | 2.5 |
| Organic acid 2 | | | 7.0 | | 6.6 | | | | | | |
| Organic acid 3 | | | | 7.0 | 6.6 | | | | | | |
| Organic acid 4 | | | | | | | | | | | |
| Film thickness (µm) | 100 | 160 | 100 | 100 | 100 | 100 | 100 | 100 | 100 | 70 | 60 |
| Volume resistivity (Ω•cm) | 9.2 × 10⁻⁴ | 3.9 × 10⁻⁵ | 4.0 × 10⁻⁴ | 1.3 × 10⁻³ | 6.6 × 10⁻³ | 1.3 × 10⁻⁴ | 2.1 × 10⁻⁴ | 8.5 × 10⁻⁴ | 5.1 × 10⁻⁵ | 6.1 × 10⁻⁵ | 2.5 × 10⁻⁴ |

**[Table 2]**

| | Examples | | | | | | | | | Comparative Examples | |
|---|---|---|---|---|---|---|---|---|---|---|---|
| | 12 | 13 | 14 | 15 | 16 | 17 | 18 | 19 | 20 | 1 | 2 |
| Tin powder 1 | | | | | | | | | | 94.7 | |
| Tin powder 2 | 92.4 | 92.4 | 83.1 | 70.1 | 69.9 | 69.3 | 61.6 | 61.6 | 46.2 | | 94.7 |
| Tin powder 3 | | | | | | | | | 46.2 | | |
| Lead-free solder 1 | | | 9.2 | 23.4 | | 23.1 | 30.8 | | | | |
| Lead-free solder 2 | | | | | 23.3 | | | | | | |
| Lead-free solder 3 | | | | | | | | 30.8 | | | |
| Resin 1 | 5.2 | 5.2 | 5.2 | 5.2 | 5.2 | 5.2 | 5.2 | 5.2 | 5.2 | 5.3 | 5.3 |
| Organic acid 1 | | 2.5 | 2.5 | 1.2 | | 2.5 | 2.5 | 2.5 | 2.5 | | |
| Organic acid 2 | 2.5 | | | | | | | | | | |
| Organic acid 3 | | | | | | | | | | | |
| Organic acid 4 | | | | | 1.6 | | | | | | |
| Film thickness (µm) | 100 | 100 | 100 | 100 | 100 | 100 | 100 | 100 | 100 | 100 | 100 |
| Volume resistivity (Ω•cm) | 1.2 × 10⁻⁴ | 1.2 × 10⁻⁴ | 1.2 × 10⁻⁴ | 7.5 × 10⁻⁵ | 1.7 × 10⁻⁴ | 7.8 × 10⁻⁵ | 8.7 × 10⁻⁵ | 1.0 × 10⁻⁴ | 8.4 × 10⁻⁵ | Unmeasurable | Unmeasurable |

As is evident from Table 1 and Table 2, the conductive films formed by the conductive resin compositions pertaining to Examples 1 to 20 all had a volume resistivity under 1.0×10⁻² (Ω•cm), with some achieving excellent conductivity under 1.0×10⁻⁴ (Ω•cm)-a level equivalent to or better than the conductivity of silver paste. This shows that conductive resin compositions that are lower in cost than silver paste, etc., while demonstrating a high level of conductivity equivalent to silver paste, were formed.

Also, it is clear from Examples 1, 2, 10, and 11, for example, that the conductive films formed by the conductive resin compositions conforming to the present invention could achieve lower volume resistivities even under varying sintered film thickness conditions applied at the time of forming of conductive films.

On the other hand, the conductive films formed by the conductive resin compositions pertaining to Comparative Examples 1 and 2 where no organic acid compound was contained had unmeasurable levels of volume resistivity, indicating poor conductivity.

## Claims

1. A conductive resin composition containing a tin powder, resin, and organic acid compound.

2. The conductive resin composition according to claim 1, which contains a lead-free solder powder.

3. The conductive resin composition according to claim 1 or 2, wherein the resin includes one or more types selected from the group consisting of polyvinyl butyral-based resins, resol-type phenol-based resins, acrylic-based resins, polyester-based resins, phenoxy resins, polyimide-based resins, epoxy-based resins, and xylene-based resins.

4. A conductive film having a volume resistivity of under 1.0×10⁻² Ω•cm, formed of the conductive resin composition according to any one of claims 1 to 3.

5. A conductive ink containing the conductive resin composition according to any one of claims 1 to 3.

6. A circuit connection material containing the conductive resin composition according to any one of claims 1 to 3.
